(19) Europäisches Patentamt

European Patent Office

Office européen des brevets

(11) **EP 1 698 670 A1**

(12) **EUROPEAN PATENT APPLICATION**
published in accordance with Art. 158(3) EPC

(43) Date of publication:
06.09.2006 Bulletin 2006/36

(51) Int Cl.:
*C08L 101/00* (2006.01)  *C08K 3/00* (2006.01)
*C08L 63/00* (2006.01)  *C08K 3/34* (2006.01)
*H05K 1/03* (2006.01)

(21) Application number: 04806975.1

(22) Date of filing: 14.12.2004

(86) International application number:
PCT/JP2004/018614

(87) International publication number:
WO 2005/056683 (23.06.2005 Gazette 2005/25)

(84) Designated Contracting States:
DE FR GB

(30) Priority: 15.12.2003 JP 2003417176

(71) Applicant: SEKISUI CHEMICAL CO., LTD.
Osaka-shi,
Osaka 530-8565 (JP)

(72) Inventors:
• SHIBAYAMA, Koichi,
SEKISUI CHEMICAL CO., LTD.
Mishima-gun,
Osaka 618-8589 (JP)

• YONEZAWA, Koji,
SEKISUI CHEMICAL CO., LTD.
Mishima-gun,
Osaka 618-8589 (JP)

(74) Representative: Merkle, Gebhard et al
TER MEER STEINMEISTER & PARTNER GbR,
Patentanwälte,
Mauerkircherstrasse 45
81679 München (DE)

(54) **THERMOSETTING RESIN COMPOSITION, MATERIAL FOR SUBSTRATE AND FILM FOR SUBSTRATE**

(57) Disclosed is a thermosetting resin composition which enables to obtain a molded article that is excellent in mechanical properties, dimensional stability and heat resistance and is further capable of maintaining the shape of the article molded before curing even after the resin composition is cured. The thermosetting resin composition contains 100 parts by weight of a thermosetting resin and 1 - 100 parts by weight of an inorganic compound dispersed in the thermosetting resin, and the dispersion particle diameter of the inorganic compound is not more than 2 μm. Not less than 75 % of the shape of an article molded before curing is maintained after the resin composition is cured. Also disclosed are a material for substrates and a film for substrates respectively composed by using such a thermosetting resin composition.

EP 1 698 670 A1

## Description

### TECHNICAL FIELD

The present invention relates to a thermosetting resin composition which is excellent in the performance to maintain the shape of an article molded before curing after the resin composition is cured and more specifically to a thermosetting resin composition which contains a thermosetting resin and an inorganic compound and is excellent in the ability to maintain the shape of the article molded after the resin composition is cured, and a material for substrates and a film for substrates composed by using such a thermosetting resin composition.

### BACKGROUND ART

In recent years, electronic equipment has been sophisticated, become multifunctional and become smaller in size, rapidly, and in electronic parts used in electronic equipment, requests for a downsizing and a weight reduction are enhanced. With the downsizing and the weight reduction of the electronic parts, materials of the electronic parts are required to further improve properties such as heat resistance, mechanical strength, electrical properties and the like. For example, as for a package of a semiconductor device or a wiring board on which a semiconductor device is surface mounted, a substance having a higher density, multifunction and high-performance is required.

A multi-layer printed-circuit board used in electronic equipment is composed of a plurality of layered insulating substrates. Hitherto, as these interlayer insulating substrates, there have been used, for example, thermosetting resin prepreg prepared by impregnating glass cloth with a thermosetting resin or a film composed of a thermosetting resin or a photo-curable resin. Also in the multi-layer printed-circuit board, it is desired to make an interlayer portion extremely thin in order to realize a high-density and low-profile printed-circuit board, and an interlayer insulating substrate using thin glass cloth or an interlayer insulating substrate not using glass cloth is required. As such an interlayer insulating substrate, there are known, for example, insulating substrates composed of (1) rubbers (elastomers), (2) thermosetting resin materials modified with acrylic resin or the like, and (3) thermoplastic resin materials mixed with a large amount of an inorganic filler.

In Japanese Unexamined Patent Publications No.2000-183539, there is disclosed a method of fabricating a multilayer insulating substrate, in which an inorganic filler having a predetermined particle diameter is mixed in varnish which is predominantly composed of an epoxy polymer having a high molecular weight and a polyfunctional epoxy resin and the resulting mixture is applied to a supporting body to form an insulating layer.

However, in the multilayer insulating substrate prepared by the above-mentioned fabrication method, it was necessary to mix a large amount of inorganic filler so that an interface area between the inorganic filler and the epoxy polymer having a high molecular weight or the polyfunctional epoxy resin is secured to adequately improve the mechanical properties such as mechanical strength. Thus, there was a problem that an insulating layer became brittle or an insulating layer for bonding to a supporting body was hard to be softened.

And, when the multilayer substrates are prepared, an insulating layer may be bonded to projection and depression portions formed such as copper patterns and via holes. In such a case, if the insulating layer is composed of a composition in which a resin is mixed with ordinary inorganic filler, such as silica, having an average particle diameter of 3 $\mu$m or larger, the viscosity of the resin is rapidly decreased by being heated in curing. Therefore, there might be cases where a resin streak is produced by resin's own weight or surface tension and an adequate insulating layer was not formed at every site.

Further, in recent years, there are pursued the development aimed at adopting optoelectronics in electronic devices and communications devices. The issues in the present state of affairs in such high polymer materials for optical communications is to be low in loss, to be excellent in heat resistance, to have a low thermal and linear expansion coefficients, to be excellent in moisture permeability and to be capable of controlling a refractive property. Herein, that it is low in loss in a material for optical communications means that the material itself does not have an optical absorption band in a wavelength range to be used for optical communication.

As a material for optical communications, there is disclosed a replicated polymeric optical waveguide in "Replicated Polymeric Optical Waveguide" Electronic Materials No.12 (2002), p.27-30. In this reference, a die (stamper) patterned after a desired core pattern is pressed against a photo-curable resin, and then the core pattern is transferred by UV irradiation. For example, when a similar processing technique was applied to a thermosetting resin, the viscosity of resin significantly decreases and fluidizes before curing the resin by a thermal curing reaction after the die (stamper) is pressed against the thermosetting resin in a state of softening. Therefore, there was a problem that a pattern cannot be transferred with high accuracy or practicable transfer accuracy cannot be attained.

Accordingly, it is strongly desired in the thermosetting material that not only the thermosetting resin is excellent in moldability such as the ability to follow projections and depressions during the thermosetting resin is not yet cured and heat resistance, and excellent in properties such as a low linear expansion coefficient and a low hygroscopicity, but also it has the ability to maintain a shape after curing. Further, when the thermosetting material is used as a material for optical communications, transparency is also required in addition to these characteristics.

## DISCLOSURE OF THE INVENTION

It is an object of the present invention to provide a thermosetting resin composition which is excellent in a thermoforming property of being capable of maintaining the shape of an article molded before curing after the resin composition is cured, attains a molded body having excellent mechanical properties, dimensional stability and heat resistance and further enables to obtain a molded article that is excellent in the ability to micro mold and properties at elevated temperature, and a material for substrates and a film for substrates composed by using such a thermosetting resin composition.

A thermosetting resin composition concerning the present invention contains 100 parts by weight of a thermosetting resin and 0.1 to 100 parts by weight of an inorganic compound dispersed in the above-mentioned thermosetting resin and is characterized in that the dispersion particle diameter of the above-mentioned inorganic compound is 2 $\mu$m or less and not less than 75% of the shape of an article molded before curing is maintained after the resin composition is cured.

And, the above inorganic compound preferably has silicon and oxygen as a constituent element, and the above inorganic compound is more preferably laminar silicate.

And, in the present invention, an epoxy resin is preferably employed as the thermosetting resin.

A material for substrates and a film for substrates concerning the present invention are characterized by being composed by using the thermosetting resin composition of the present invention.

The thermosetting resin composition concerning the first present invention is excellent in the ability to maintain the shape of a molded article since an inorganic compound is mixed in the thermosetting resin composition in an amount 0.1 to 100 parts by weight with respect to 100 parts by weight of a thermosetting resin, the dispersion particle diameter of the inorganic compound is 2 $\mu$m or less and further not less than 75% of the shape of an article molded before curing is maintained after the resin composition is cured. Accordingly, a temperature raising rate in thermoforming can be increased or a pressing speed can be increased. Therefore, it becomes possible to enhance the productivity in molding effectively. And, since the inorganic compound is dispersed in the above-mentioned thermosetting resin and the thermosetting resin is cured by heat, a molded article, which is obtained by curing the thermosetting resin composition of the present invention, is also excellent in mechanical properties, dimensional stability and heat resistance.

When laminar silicate is used as the above inorganic compound, not only inhibition of a change in dimension or a rate of maintaining a shape at the time of curing is effectively enhanced, but also a molded article having excellent heat insulation and heat resistance can be attained.

When an epoxy resin is used as a thermosetting resin, in accordance with the present invention, not only a rate of maintaining a shape is enhanced, but also a molded article having excellent mechanical properties, dimensional stability and heat resistance can be attained.

The material for substrates and the film for substrates concerning the present invention are composed by using the thermosetting resin composition concerning the present invention. Accordingly, not only properties, dimensional accuracy and heat resistance of the material for substrates and the film for substrates are enhanced, but also the material for substrates and the film for substrates, having various shapes, can be obtained with high accuracy by thermoforming.

## BRIEF DESCRIPTION OF THE DRAWINGS

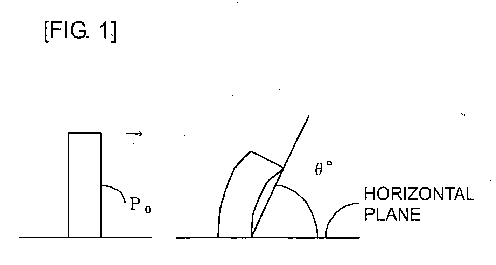

Figure 1 is a view illustrating a method of evaluating a self-supporting property after molding as one of evaluations of the ability to maintain a shape in Examples and Comparative Examples.

## BEST MODE FOR CARRYING OUT THE INVENTION

Hereinafter, the specific aspects for carrying out the present invention will be described to clarify the present invention.

When a thermosetting resin composition of the present invention is used, squeeze and bleed of resin and cracks of a molded article, which are associated with a rapid change in temperature or in pressure in usual thermoforming of a thermosetting resin composition, hardly take place. Incidentally, usual thermoforming includes widely, for example, compression molding, transfer molding, heat laminating, and SMC (sheet molding compound) molding.

In general thermoforming, in the case of a thermoplastic resin such as an epoxy resin, an increase in fluidity associated with temperature raising and an increase in viscosity by a curing reaction take place simultaneously. Therefore, it is important to control melt viscosity by adjusting temperature and/or pressure during thermoforming, and it was impossible to enhance productivity by rapid temperature raising or pressing. However, by employing the thermosetting resin composition of the present invention, a temperature raising rate can be increased or a pressing speed can be increased, and thereby molding efficiency of a thermosetting resin composition can be enhanced.

The thermosetting resin composition concerning the present invention contains 100 parts by weight of a thermosetting resin and 0.1 to 100 parts by weight of an inorganic compound and not less than 75% of the shape of an article molded before curing is maintained after the resin composition is cured. When a height of an article molded into the form of a cylinder is denoted by H and a diameter of the article is denoted by D, a rate of maintaining a shape, which is represented as not less than 75% described above, canbe determined from the ratio between H/D values measured before and after curing. For example, when a resin is molded into a shape in which H/D is equal to 2 before curing, the rate of maintaining a shape is 75% or more if H/D is 1.5 or more after curing.

Further, in the present invention, a method of molding the thermosetting resin composition is not particularly limited and the thermosetting resin composition is molded by an appropriate method such as pressing and compression.

Needless to say that it is possible cure the thermosetting resin composition in a state of filling in a die, if the thermosetting resin has the rate of maintaining a shape of 75% or more, it becomes possible to transfer the configuration of a die to the thermosetting resin without curing the thermosetting resin in a state of filling in a die and to heat cure it after removing the die, and therefore the productivity of molding a profile of the thermosetting resin can be easily enhanced. In addition, the above-mentioned rate of maintaining a shape is more preferably 80% or more.

In the present invention, the inorganic compound mixed in the above thermosetting resin composition is not particularly limitedbut its dispersionparticle diameter in the thermosetting resin is preferably 2 μm or less. Generally, when an inorganic compound is added to a thermosetting resin, the elastic modulus of a composite material to be obtained or the viscosity at the time of elevated temperature suchas the time of thermally melting becomes large. Particularly, when an inorganic compound having a small particle diameter is added, an interface area between the resin and the inorganic compound becomes large and therefore the viscosity of the resin at elevated temperature increases. Thereby, a releasing property from a die is also enhanced. In the present invention, by mixing an inorganic compound having a dispersion particle diameter of 2 μm or less, the above-mentioned inhibition of a change in dimension or rate of maintaining a shape of the thermosetting resin composition is effectively enhanced. Preferably, an inorganic compound having a dispersion particle diameter of 1 μm or less is used.

Examples of the above inorganic compounds include silica, talc, mica, metal hydroxide, calcium carbonate, silicate and the like. Particularly, as an inorganic compound having a dispersion particle diameter of 2 μm or less in a resin, fine powder silica containing silicon and oxygen such as fumed silica and AEROSIL is suitably employed because it has a large specific surface area and a contact surface with resin becomes large.

Alternatively, in the resin composition concerning the present invention, an inorganic compound having a dispersion particle diameter of 2 μm or less in a resin is more preferably laminar silicate. The laminar silicate is an inorganic compound inplate form and a large aspect ratio. When the laminar silicate is added, the elastic modulus of a composite material to be obtained or the viscosity at the time of elevated temperature such as the time of thermally melting is enhanced. Particularly, when a crystal of the laminar silicate in flake form is delaminated and highly dispersed in the thermosetting resin, an interface area between the thermosetting resin and the laminar silicate becomes very large and therefore the viscosity of the resin at elevated temperature can be enhanced even when a small amount of the laminar silicate is added.

Examples of the above laminar silicates include smectite clay minerals such as montmorillonite, hectorite, saponite, beiderite, stevensite, nontronite and the like, swelling mica, vermiculite, hallosite and the like. Among others, at least one species selected from the groupconsisting ofmontmorillonite, hectorite, swelling mica, and vermiculite is suitably used. These laminar silicates may be used alone or in combination of two or more species.

When the laminar silicate is at least one species selected from the group consisting of montmorillonite, hectorite, swellingmica, and vermiculite, thedispersibilityof the laminar silicate in resin is enhanced, and an interface area between the resin and the laminar silicate becomes large. Accordingly, the effect of constraining a resin is enhanced, and therefore resin strength and dimensional stability at elevated temperature can be improved.

The above configuration of the crystal of the laminar silicate is not particularly limited, but a preferred lower limit of an average length is 0.01 μm and a preferred upper limit is 3 μm, a preferred lower limit of a thickness is 0.001 μm and a preferred upper limit is 1 μm and a preferred lower limit of an aspect ratio is 20 and a preferred upper limit is 500, and a more preferred lower limit of an average length is 0.05 μm and a more preferred upper limit is 2 μm, a more preferred lower limit of a thickness is 0.01 μm and a more preferred upper limit is 0.5 μm and a more preferred lower limit of an aspect ratio is 50 and a more preferred upper limit is 200. The above laminar silicate preferably has a large effect of shape anisotropy defined by the following equation (1):

$$\text{Effect of shape anisotropy} = \text{Area of crystal surface}$$

$$\text{(A)/Area of crystal surface (B)} \qquad \text{(1),}$$

wherein the crystal surface (A) refers to the surface of a layer and the crystal surface (B) refers to the side of a layer. By employing the laminar silicate having a large effect of shape anisotropy, a resin obtained from the resin composition of the present invention has excellent mechanical properties.

An exchangeable metal cation existing between layers of the above laminar silicate refers to an ion of metal such as sodium or calcium, which exists at the surface of the crystal of the laminar silicate in flake form. Since these metal ions have a property of exchanging cations with a cationic material, it is possible to intercalate various materials having a cationic property between crystal layers of the above laminar silicate.

A cation-exchange capacity of the above laminar silicate is not particularly limited, but a preferred lower limit of the cation-exchange capacity is 50 meq/100 g and a preferred upper limit is 200 meq/100 g. When the cation-exchange capacity is less than 50 meq/100 g, an amount of a cationic material intercalated between crystal layers of the laminar silicate by the cation-exchange becomes less and therefore a portion between crystal layers may not be adequately non-polarized (converted to a hydrophobic substance). When the cation-exchange capacity is more than 200 meq/100 g, the crystal in flake form may be hardly delaminated because the binding force between crystal layers of the laminar silicate becomes too strong.

The above laminar silicate is preferably a substance which is chemically treated to have improved dispersibility in resin. Hereinafter, the laminar silicate thus treated is also referred to as an organized laminar silicate. The above-mentioned chemical treatment can be performed by, for example, methods of from chemical modification (1) to chemical modification (6) described later. These methods of chemical modification may be used alone or in combination of two or more species of them.

The above method of chemical modification (1) is also referred to as a cation-exchange method by a cationic surfactant and specifically a method in which an interlaminar portion of laminar silicate is cation-exchanged with a cationic surfactant and converted to a hydrophobic substance in advance when obtaining the resin composition of the present invention using a resin of the low polarity. By converting the interlaminar portion of laminar silicate to a hydrophobic substance in advance, an affinity of the laminar silicate for a resin of the lowpolarity is enhanced and thereby the laminar silicate can be more uniformly dispersed finely in the resin of the low polarity.

The above-mentioned cationic surfactant is not particularly limited and examples of the cationic surfactants include quaternary ammonium salt, quaternary phosphonium salt and the like. Among others, alkyl ammonium ion having six or more carbon atoms, aromatic quaternary ammonium ion or heterocyclic quaternary ammonium ion is suitably used because a portion between crystal layers of the laminar silicate can be adequately converted to a hydrophobic substance.

The above quaternary ammonium salt is not particularly limited and examples of them include trimethylalkylammonium salt, triethylalkylammonium salt, tributylalkylammonium salt, dimethyldialkylammonium salt, dibutyldialkylammonium salt, methylbenzylalkylammonium salt, dibenzyldialkylammoniumsalt, trialkylmethylammonium salt, trialkylethylammonium salt, trialkylbutylammonium salt; quaternary ammonium salts having an aromatic ring such as benzylmethyl{2-[2-(p-1,1,3,3-tetramethylbutylphenoxy)ethoxy]ethyl}ammonium chloride; quaternary ammonium salts derived from aromatic amine such as trimethylphenylammonium; quaternary ammonium salts having a heterocycle such as alkylpyridinium salt and imidazolium salt; dialkyl quaternary ammonium salts having two polyethylene glycol chains, dialkyl quaternary ammonium salts having two polypropylene glycol chains, trialkyl quaternary ammonium salts having a polyethylene glycol chain, and trialkyl quaternary ammonium salts having a polypropylene glycol chain. Among others, lauryl trimethyl ammonium salt, stearyl trimethyl ammonium salt, trioctylmethylammonium salt, distearyl dimethyl ammonium salt, dehydrogenated tallow dimethyl ammonium salt, distearyl dibenzyl ammonium salt, and N-polyoxyethylene-N-lauryl-N,N-dimethyl ammonium salt are suitable. These quaternary ammonium salts may be used alone or in combination of two or more species.

The above-mentioned quaternary phosphonium salt is not particularly limited and examples of them include dodecyltriphenylphosphonium salt, methyltriphenylphosphonium salt, lauryl trimethyl phosphonium salt, stearyl trimethyl phosphonium salt, trioctylmethylphosphonium salt, distearyl dimethyl phosphonium salt, and distearyl dibenzyl phosphonium salt. These quaternary phosphonium salts may be used alone or in combination of two or more species.

The above method of chemical modification(2) is a method of chemically treating a hydroxyl group, which exists at the surface of a crystal of an organized laminar silicate prepared by chemically treating the laminar silicate by the method of chemical modification(1), with a compound having one or more functional groups capable of chemically bonding to a hydroxyl group or one or more functional groups having a large chemical affinity for a hydroxyl group on a terminal of a molecule.

The above-mentioned functional group capable of chemically bonding to a hydroxyl group or functional group having a large chemical affinity for a hydroxyl group is not particularly limited and examples of these functional groups include an alkoxy group, a glycidyl group, a carboxyl group (including dibasic acid anhydride), a hydroxyl group, an isocyanate group and an aldehyde group.

The above-mentioned compound having the functional group capable of chemically bonding to a hydroxyl group or the above-mentioned compound having the functional group having a large chemical affinity for a hydroxyl group is not particularly limited and examples of these compounds include a silane compound, a titanate compound, a glycidyl compound, carboxylic acids, sulfonic acids and alcohols, which have the above functional group. These compounds may be used alone or in combination of two or more species.

The above-mentioned silane compound is not particularly limited and examples of the silane compounds include vinyltrimethoxysilane, vinyltriethoxysilane, vinyltris(beta-methoxyethoxy)silane, gamma-aminopropyltrimethoxysilane, gamma-aminopropylmethyldimethoxysilane, gamma-aminopropyldimethylmethoxysilane, gamma-aminopropyltriethoxysilane, gamma-aminopropylmethyldiethoxysilane, gamma-aminopropyldimethylethoxysilane, methyltriethoxysilane, dimethyldimethoxysilane, trimethylmethoxysilane, hexyltrimethoxysilane, hexyltriethoxysilane, N-beta-(aminoethyl) gamma-aminopropyltrimethoxysilane, N-beta-(aminoethyl)gamma-aminopropyltriethoxysilane, N-beta-(aminoethyl) gamma-aminopropylmethyldimethoxysilane, octadecyltrimethoxysilane, octadecyltriethoxysilane, gamma-methacryloxypropylmethyldimethoxysilane, gamma-methacryloxypropylmethyldiethoxysilane, gamma-methacryloxypropyltrimethoxysilane, and gamma-methacryloxypropyltriethoxysilane. These silane compounds may be used alone or in combination of two or more species.

The above method of chemical modification(3) is a method of chemically treating a hydroxyl group, which exists at the surface of a crystal of an organized laminar silicate prepared by chemically treating the laminar silicate by the method of chemical modification(1), with a functional group capable of chemically bonding to a hydroxyl group or a functional group having a large chemical affinity for a hydroxyl group, and a compound having one or more reactive functional group on a terminal of a molecule.

The above method of chemical modification (4) is a method of chemically treating the surface of a crystal of an organized laminar silicate prepared by chemically treating the laminar silicate by the method of chemical modification (1) with a compound having an anionic surface activity.

A compound having the above anionic surface activity is not particularly limited as long as it can chemically treat the laminar silicate by ionic interaction. Examples of the above compounds having the anionic surface activity include sodium laurate, sodium stearate, sodium oleate, higher alcohol sulfuric acid salt, secondary higher alcohol sulfuric acid salt, and unsaturated alcohol sulfuric acid salt. These compounds may be used alone or in combination of two or more species of them.

The above method (5) of chemical modification is a method of chemically treating with a compound having one or more reactive functional groups at a site other than an anion site in a molecular chain among the above compound having the anionic surface activity.

The above method of chemical modification(6) is a method of using further a resin having a functional group capable of reacting with laminar silicate such as maleic anhydride modified polyphenylene ether resin for an organized laminar silicate prepared by chemically treating the laminar silicate by any one of the methods of from chemical modification(1) to chemical modification(5).

The above laminar silicate is preferably dispersed in the resin composition of the present invention in such a way that an average interlayer distance of a (001) plane, measured by a wide-angle X-ray dif fraction measuring method, is 3 nmor larger and a part of or all of laminates have five layers or less. By dispersing the laminar silicate in such a way that the above-mentioned average interlayer distance is 3 nm or larger and a part of or all of laminates have five layers or less, an interface area between resin and laminar silicate becomes adequately large. Further, a distance between crystals of the laminar silicate in flake form becomes proper and effects of improvement in properties at elevated temperature, mechanical properties, heat resistance and dimensional stability by virtue of dispersion can be adequately attained.

A preferred upper limit of the above average interlayer distance is 5 nm. When the above average interlayer distance is larger than 5 nm, the crystal in flake form of the laminar silicate is separated in every layers and an interaction becomes weak nonsignificantly, and therefore constraining strength at elevated temperature may be reduced and adequate dimensional stability may not be attained.

In addition, in the present specification, the average interlayer distance of the laminar silicate refers to an average of an interlayer distance in the case where a crystal of the laminar silicate in flake form is considered as a layer. The average interlayer distance can be determined by peaks of X-ray diffraction and a transmission electron microphotograph, namely, a wide-angle X-ray diffraction measuring method.

That the laminar silicate is dispersed in such a way that a part of or all of laminates become a laminate of five layers or less, as described above, means specifically that an interaction between the crystals in flake form of the laminar silicate is reduced and a part of or all of a laminate of the crystals in flake is dispersed. Not less than 10% of the laminate of the laminar silicate is preferably dispersed in a state of five layers or less and not less than 20% of the laminate of the laminar silicate is more preferably dispersed in a state of five layers or less.

In addition, a rate of laminar silicate dispersed in the form of a laminate of five layers or less in a resin composition can be derived from the following equation (2), using the number X of layers in total laminates and the number Y of layers in laminates dispersed in the form of a laminate of five layers or less among the total laminates, which have been determined by observing the resin composition under a magnification of 50000 times to 100000 times with a transmission electron microscope and counting the number of laminates of laminar silicate which can be observed in a certain area and the number of layers in these laminates.

$$\text{Rate of laminar silicate dispersed in the form of a laminate}$$

$$\text{of five layers or less (\%)} = (Y/X) \times 100 \quad (2)$$

And, number of layers laminated in a laminate of laminar silicate is preferably 5 or less to attain an effect of the dispersion of laminar silicate.

However, in practice, the laminar silicate can adequately exert the above-mentioned effect if the laminar silicate is dispersed in a state of the order of 3 in number of laminated layers in a laminate.

As a method of reducing the number of laminated layers, there is a method of increasing a chemical treatment amount such as an amount of a cationic surfactant with which the laminar silicate is cation-exchanged so that the dispersibility of the laminar silicate might be improved. However, in this case, the deterioration of properties may occur due to a large amount of the mixed cationic surfactant. Further, there is a method of employing more severe conditions in dispersing the laminar silicate, and for example, there are the technique of enhancing a shearing force during extrusion in the case of dispersing the laminar silicate with a extruder and the technique of increasing the number of revolutions of a rotating blade in the case of stirring the laminar silicate with a mixer.

Therefore, not less than 30% of the laminate of the laminar silicate is preferably dispersed in a state of three layers or more. And, a rate of the laminate of the laminar silicate dispersed in a state of three layers or more is preferably 70% or less because it becomes hard to attain the above-mentioned properties if the rate of the laminar silicate in three layers or more increases excessively.

In the resin composition of the present invention, when laminar silicate, in which an average interlayer distance of a (001) plane, measured by a wide-angle X-ray diffraction measuring method, is 3 nm or larger and a part of or all of laminates are a laminate of five layers or less, is dispersed, an interface area between the resin and the laminar silicate becomes adequately large and an interaction between the resin and the surface of the laminar silicate becomes large. Therefore, melt viscosity is enhanced, a property of thermoforming such as hot pressing is improved, and in addition to this a shape of an article molded by texturing or embossing is easy to maintain and simultaneously a releasing property from a die is excellent. And, mechanical properties such as elastic modulus are improved in a wide temperature range of from room temperature to elevated temperature. Further, mechanical properties can be maintained even at a high temperature of the glass transition point Tg or the melting point of resin or higher and a linear expansion coefficient at elevated temperature can also be suppressed. The reason for this is not clear, but it is considered that these properties are exerted because the laminar silicate in a state of dispersing finely acts as a kind of quasi-crosslinking point even in a temperature range of a glass transition point Tg or a melting point or higher. And, it is considered that since this quasi-crosslinking point does not contain a covalent bond, this quasi-crosslinking point is not maintained at a given shear rate and therefore sufficient fluidity is retained in thermoforming. On the other hand, since a distance between crystals of the laminar silicate in flake form alsobecomes proper, a sintered body, in which the crystal of the laminar silicate in flake moves to form a flame retardant film in firing, becomes apt to be formed. Since this sintered body is formed at the early stage in firing, this sintered body can cut off not only an external supply of oxygen but also a flammable gas produced by combustion, and therefore the resin composition of the present invention exerts excellent flame retardancy.

Further, since in the above resin composition, the laminar silicate is finely dispersed in a size of nanometer, the resin composition is excellent in transparency. And, processing by drill hole boring or laser hole boring is easy since there are not localized inorganic compound pieces of the large size.

A method of dispersing laminar silicate in a thermosetting resin is not particularly limited and includes, for example, a method of using organized laminar silicate, a method of mixing resin and laminar silicate by normal technique, a method of using a dispersant and a method of mixing laminar silicate into resin in a state of being dispersed in a solvent. As for an amount of the above inorganic compound to be mixed with respect to 100 parts by weight of the above thermosetting resin, a lower limit of the amount to be mixed is 0.1 parts by weight and an upper limit is 100 parts by weight. When the amount of the above inorganic compound to be mixed is less than 0.1 parts by weight, effects of improvements in properties at elevated temperature and water absorption become small and the ability to maintain a shape after curing is deteriorated. When the amount of the above inorganic compound to be mixed is more than 100 parts by weight, the resin composition becomes poor in practicality because the density (specific gravity) of the resin composition of the present invention increases and the mechanical strength of the resin composition is deteriorated. A preferred lower limit of the amount of the above inorganic compound to be mixed is 1 part by weight and a preferred upper limit is 80 parts by weight. When the amount of the above inorganic compound to be mixed is less than 1 part by weight, an adequate effect of improvement in properties at elevated temperature may not be attained in molding the resin composition of the present invention into a low-profile article. When the amount of the above inorganic compound to be mixed is more than 80 parts by weight, moldability may be deteriorated. And, a more preferred range of the amount of the above inorganic compound to be mixed is 1 to 70 parts by weight. When the amount of the inorganic compound to be mixed is 1 to 70 parts by weight, there is not a problematic region in mechanical properties and suitability for a process, and the ability to maintain a shape and suf f icient properties at elevated temperature after molding, and low water absorption are attained.

A furthermore preferred range of the amount of the inorganic compound to be mixed with respect to 100 parts by weight of the thermosetting resin is 1 to 60 parts by weight, and particularly preferred range is 5 to 40 parts by weight.

And, when the thermosetting resin composition is cured in a state of being filled in a die, an amount of the inorganic compound to be mixed in the above thermoplastic resin composition may be 0.1 to 40 parts by weight, and when this amount is less than 0.1 parts by weight, the ability to maintain a shape cannot be attained, and when it is more than 40 parts by weight, an effect of improving the dimensional stability at the time of curing is reduced. A preferred range of the amount of the inorganic compound to be mixed is 1 to 20 parts by weight.

When molding the resin composition into a desired shape, the resin composition preferably contains the laminar silicate in an amount 0.2 to 40 parts by weight with respect to 100 parts by weight of resin content containing the above epoxy resin and the above epoxy resin curing agent. The resin composition more preferably contains the laminar silicate in an amount 0.5 to 20 parts by weight, and furthermore preferably contains the laminar silicate in an amount 1.0 to 10 parts by weight with respect to 100 parts by weight of the above resin content. When the amount of the laminar silicate contained is less than 0.2 parts by weight, mechanical properties after curing may be deteriorated, and when the amount of the laminar silicate contained is more than 40 parts by weight, the viscosity of resin increases and it becomes difficult to mold the resin composition into a desired shape.

When the thermosetting resin composition contains an inorganic compound other than laminar silicate, the thermosetting resin composition preferably contains the laminar silicate and the inorganic compound in the proportions in a range of 1:1 to 1:20. When the proportions fall within a range of 1:1 to 1:20, the viscosity of resin does not significantly increase and further mechanical properties can be improved. Therefore, when the proportions fall within a range of 1:1 to 1:20, the resin composition can be suitably used for built-up applications since a flow property becomes good and in this case, it is excellent in the ability to follow and the flatness, and further excellent in the mechanical properties.

The thermosetting resin used in the present invention may be liquid, semisolid or solid at room temperature. And, the above-mentioned thermosetting resin refers to resins in which a material of a relatively low molecular weight exhibiting fluidity at room temperature or by heating can reacts chemically through a curing reaction or a crosslinking reaction by a temperature effect or by using a curing agent and a catalyst in combination as required to increase its own molecular weight and simultaneously form a three-dimensional network structure to become a resin which does not dissolve and melt.

The above-mentioned thermosetting resin is not particularly limited and examples of the thermosetting resins include an epoxy resin, a thermosetting modified polyphenylene ether resin, a thermosetting polyimide resin, a silicon resin, a benzoxazine resin, a melamine resin, a urea resin, an allyl resin, a phenol resin, an unsaturated polyester resin, a bismaleimide-triazine resin, an alkyd resin, a furan resin, a polyurethane resin and an aniline resin. Among others, an epoxy resin, a thermosetting modified polyphenylene ether resin, a thermosetting polyimide resin, a silicon resin, a benzoxazine resin, and a melamine resin are suitable. These thermosetting resins may be used alone or in combination of two or more species.

In the present invention, the epoxy group is preferably used as the above thermosetting resin. When the epoxy group is used, it is possible to obtain a molded article, which is not only excellent in the suppression of changes in dimension and the ability to maintain a shape during curing, but also excellent in the mechanical properties, the dimensional accuracy and the heat resistance in accordance with the present invention.

The above epoxy resin refers to an organic compound having at least one epoxy group. The number of the epoxy groups in the above epoxy resin is preferably one or more per a molecule, and more preferably two or more per a molecule. Here, the number of the epoxy groups in a molecule can be determined by dividing the total number of the epoxy groups in the epoxy resin by the total number of molecules in the epoxy resin.

As the above epoxy resin, a publicly known epoxy resin can be used, and the above epoxy resin includes, for example, epoxy resins (1) to (11) described below. These epoxy resins may be used alone or in combination of two or more species.

The above epoxy resin (1) includes, for example, bisphenol type epoxy resins such as bisphenol A type epoxy resin, bisphenol F type epoxy resin, bisphenol AD type epoxy resin and bisphenol S type epoxy resin; novolac type epoxy resins such as phenol novolac type epoxy resin and cresol novolac type epoxy resin; aromatic epoxy resins such as trisphenolmethane triglycidyl ether, biphenyl type epoxy resin and naphthalene type epoxy resin; alicyclic epoxy resins such as dicyclopentadiene type epoxy resin; and hydrogenated products or bromides thereof.

When the epoxy resin includes at least one species selected from the group consisting of bisphenol type epoxy resin, biphenyl type epoxy resin, dicyclopentadiene type epoxy resin and naphthalene type epoxy resin, it is excellent in the strength of material and the dimensional stability at elevated temperature because a molecule chain is rigid. Further, since the epoxy resin has a high packing property, it is also excellent in electrical properties such as dielectric loss tangent.

The above epoxy resin (2) includes, for example, alicyclic epoxy resins such as 3,4-epoxycyclohexylmethyl-3,4-epoxycyclohexanecarboxylate, 3,4-epoxy-2-methylcyclohexylmethyl-3,4-epoxy-2-methylcycloh exanecarboxylate, bis(3,4-epoxycyclohexyl)adipate, bis(3,4-epoxycyclohexylmethyl)adipate, bis(3,4-epoxy-6-methylcyclohexylmethyl)adipate, 2-(3,4-epoxycyclohexyl-5,5-spiro-3,4-epoxy)cyclohexanone-m-dioxane and bis(2,3-epoxycyclopentyl)ether. A commercially available resin among such the epoxy resins (2) includes, for example, a trade name "EHPE-3150" produced by DAICEL CHEMICAL INDUSTRIES, LTD. (softening point 71°C).

The above epoxy resin (3) includes, for example, aliphatic epoxy resins such as 1,4-butanediol diglycidyl ether, 1,6-hexanediol diglycidyl ether, glycerin triglycidyl ether, trimethylol propane triglycidyl ether, polyethylene glycol diglycidyl ether, polypropylene glycol diglycidyl ether and polyglycidyl ethers of long chain polyols including polyoxyalkylene glycol containing an alkylene group having 2 to 9 (preferably 2 to 4) carbon atoms and poly(tetramethylene ether)glycol.

The above epoxy resin (4) includes, for example, glycidyl ester type epoxy resins such as phthalic acid diglycidyl ester, tetrahydrophthalic acid diglycidyl ester, hexahydrophthalic acid diglycidyl ester, glycidyl-p-oxybenzoic acid, salicylic acidglycidyl ether-glycidyl ester and dimer acid glycidyl ester, and hydrogenated products thereof.

The above epoxy resin (5) includes, for example, glycidyl amine type epoxy resins such as triglycidyl isocyanurate, N,N'-diglycidyl derivatives of cyclic alkylene urea, N,N,O-triglycidyl derivatives of p-aminophenol and N,N,O-triglycidyl derivatives of m-aminophenol, and hydrogenated products thereof.

The above epoxy resin (6) includes, for example, copolymers of glycidyl (meth) acrylate and radically polymerizable monomers such as ethylene, vinyl acetate, (meth)acrylate and the like.

The above epoxy resin (7) includes, for example, polymers based on conjugate diene compounds such as epoxidized polybutadiene, or a polymer obtained by epoxidizing a double bond of unsaturated carbons in a polymer of a partial hydrogenation product thereof.

The above epoxy resin (8) includes, for example, block copolymers obtained by epoxidizing a double bond of unsaturated carbons in a conjugate diene compound in a block copolymer having a polymer block based on a vinyl aromatic compound such as epoxidized SBS and a polymer block based on a conjugate diene compound or a polymer block of a partial hydrogenation product thereof in the same molecule.

The above epoxy resin (9) includes, for example, polyester resins having one or more, preferably two or more epoxy groups in a molecule.

The above epoxy resin (10) includes, for example, urethane modified epoxy resins and polycaprolactone modified epoxy resins obtained by introducing a urethane bond and a polycaprolactone bond into the structures of the above epoxy resins (1) to (9).

The above epoxy resin (11) includes, for example, rubber modified epoxy resins obtained by including rubber components such as NBR, CTBN, polybutadiene and acrylic rubber in the above epoxy resins (1) to (10). Alternatively, a resin or an oligomer having at least one oxirane ring may be added other than the epoxy resin.

In heat curing the above epoxy resins, a curing agent is preferably used. As such a curing agent, a publicly known curing agent for epoxy resins can be used. Such a curing agent include, for example, amine compounds, compounds such as a polyaminoamide compound synthesized from an amine compound, tertiary amine compounds, imidazole compounds, hydrazide compounds, melamine compounds, acid anhydrides, phenol compounds, thermal latent cationic polymerization catalysts, dicyanamide and a derivative thereof. These curing agents may be used alone or in combination of two or more species.

The above-mentioned amine compound is not particularly limited and examples of the amine compounds include chain aliphatic amines such as ethylenediamine, diethylenetriamine, triethylenetetramine, tetraethylenepentamine, polyoxypropylenediamine and polyoxypropylenetriamine, and derivatives thereof; cyclic aliphatic amines such as menthen diamine, isophorone diamine, bis(4-amino-3-methylcyclohexyl)methane, diaminodicyclohexyl methane, bis (aminomethyl) cyclohexane, N-aminoethyl piperazine and 3,9-bis(3-aminopropyl)2,4,8,10-tetraoxaspiro(5,5) undecane, and derivatives thereof; and aromatic amines such as m-xylenediamine, alpha-(m/p-aminophenyl)ethylamine, m-phenylenediamine, diaminodiphenylmethane, diaminodiphenylsulfone and alpha,alpha-bis(4-aminophenyl)-p-diisopropylbenzene, and derivatives thereof.

The above-mentioned compounds synthesized from the amine compound is not particularly limited and examples of these compounds include polyaminoamide compounds and derivatives thereof, which are synthesized from the above amine compound and a carboxylic acid compound such as succinic acid, adipic acid, azelaic acid, sebacic acid, dodecanedioic acid, isophthalic acid, terephthalic acid, dihydroisophthalic acid, tetrahydroisophthalic acid and hexahydroisophthalic acid; polyaminoimide compounds and derivatives thereof, which are synthesized from the above amine compound and a maleimide compoundsuch asdiaminodiphenylmethane-bismaleimide;ketimine compounds and derivatives thereof, which are synthesized from the above amine compound and a ketone compound; and polyamino compounds and derivatives thereof, which are synthesized from the above amine compound and a compound such as an epoxy compound, urea, thiourea, an aldehyde compound, a phenol compound or an acrylic compound.

The above-mentioned tertiary amine compound is not particularly limited and examples of the tertiary amine compounds include N,N-dimethylpiperazine, pyridine, picoline, benzyldimethylamine, 2-(dimethylaminomethyl)phenol, 2,4,6-tris(dimethylaminomethyl)phenol, 1,8-diazabiscyclo[5,4,0]undecane-1 and derivatives thereof.

The above-mentioned imidazole compound is not particularly limited and examples of the imidazole compounds include 2-methylimidazole, 2-ethyl-4-methylimidazole, 2-undecylimidazole, 2-heptadecylimidazole, 2-phenylimidazole and derivatives thereof.

The above-mentioned hydrazide compound is not particularly limited and examples of the hydrazide compounds include 1,3-bis(hydrazinocarboethyl)-5-isopropylhydantoin, 7,11-octadecadien-1,18-dicarbohydrazide, dihydrazide eicosadioate, adipic dihydrazide and derivatives thereof.

The above-mentioned melamine compound is not particularly limited and examples of the melamine compounds include 2,4-diamino-6-vinyl-1,3,5-triazine and a derivative thereof.

The above-mentioned acid anhydride is not particularly limited and examples of the acid anhydrides include phthalic anhydride, trimellitic anhydride, pyromelletic anhydride, benzophenonetetracarboxylic anhydride, ethylene glycol bisanhydrotrimellitate, glycerol trisanhydrotrimellitate, methyltetrahydrophthalic anhydride, tetrahydrophthalic anhydride, nadic anhydride, methylnadic anhydride, trialkyltetrahydrophthalic anhydride, hexahydrophthalic anhydride, methylhexahydrophthalic anhydride, 5-(2,5-dioxotetrahydrofuryl)-3-methyl-3-cyclohexene-1,2-dic arboxylic anhydride, trialkyltetrahydrophthalic anhydride-maleic anhydride adduct, dodecenylsuccinic anhydride, polyazelaic anhydride, dodecanoic diacid anhydride, chlorendic anhydride and a derivative thereof.

The above-mentioned phenol compound is not particularly limited and examples of the phenol compounds include phenolic novolac, o-cresol novolac, p-cresol novolac, t-butylphenol novolac, dicyclopentadiene cresol and derivatives thereof.

The above-mentioned thermal latent cationic polymerization catalyst is not particularly limited and examples of the catalysts include ionic thermal latent cationic polymerization catalyst such as benzyl sulfonium salt, benzyl ammonium salt, benzyl pyridinium salt and benzyl phosphonium salt, in which antimony hexafluoride, phosphorus hexafluoride and boron tetrafluoride are pair anions; and nonionic thermal latent cationic polymerization catalyst such as N-benzylphthalimide and aromatic sulfonate.

Examples of the above-mentioned thermosetting modified polyphenylene ether resins include resins obtained by modifying the above polyphenylene ether resin with a functional group having a thermosetting property such as a glycidyl group, an isocyanate group and an amino group. These thermosetting modified polyphenylene ether resins may be used alone or in combination of two or more species.

The above-mentioned thermosetting polyimide resin is a resin having an imide bond in a main chain of a molecule, and examples of these resins include specifically a polycondensation product of aromatic diamine and aromatic tetracarboxylic acid, a bismaleimide resin which is a product of addition polymerization of aromatic diamine and bismaleimide, a polyaminobismaleimide resin which is a product of addition polymerization of aminobenzoic hydrazide and bismaleimide and a bismaleimide-triazine resin composed of a dicyanate compound and a bismaleimide resin. Among others, the bismaleimide-triazine resin is suitably used. These thermosetting polyimide resins may be used alone or in combination of two or more species.

The above-mentioned silicon resin is a resin containing a silicon-silicon bond, a silicon-carbon bond, a siloxane bond or a silicon-nitrogen bond in a molecule chain, and it includes, for example, polysiloxane, polycarbosilane, polysilazane and the like.

The above-mentioned benzoxazine resin refers to a monomer capable of polymerizing by ring-opening an oxazine ring of a benzoxazine monomer and a resin obtained by polymerizing by ring-opening. The above-mentioned benzoxazine monomer is not particularly limited and examples of the benzoxazine monomers include substances obtained by the combination of a substituent such as a phenyl group, a methyl group, a cyclohexyl group or the like and nitrogen of the oxazine ring, and substances obtained by the combination of the respective nitrogen of two oxazine rings and one substituent such as a phenyl group, a methyl group, a cyclohexyl group or the like.

The above-mentioned urea resin includes, for example, thermosetting resins obtained by an addition-condensation reaction of urea and formaldehyde. A curing agent used in a curing reaction of the above urea resin is not particularly limited and examples of the above-mentioned curing agent include sensitive curing agents consisting of acidic salt such as salt of inorganic acid and sodium, salt of organic acid and sodium and acidic sodium sulfate; and latent curing agents like salt such as carboxylate, an acid anhydride, ammonium chloride and ammonium phosphate. Among others, the latent curing agent is preferred from the viewpoint of a shelf life.

The above-mentioned allyl resin includes a substance obtained by polymerization and a curing reaction of diallyl phthalate monomer. The above-mentioned diallyl phthalate monomer includes, for example, an ortho-body, an iso-body and tere-body. A catalyst of the curing reaction is not particularly limited but it is suitable, for example, to use t-butylperbenzoate and di-t-butylperoxide in combination.

A photo-curable resin may be further mixed in the resin composition of the present invention to the extent of not impairing the attainment of issues of the present invention. The photo-curable resin includes, for example, an epoxy resin, a thermosetting modified polyphenylene ether resin, a thermosetting polyimide resin, a silicon resin, a benzoxazine resin, a melamine resin, a urea resin, an allyl resin, a phenol resin, an unsaturated polyester resin, a bismaleimide-triazine resin, an alkyd resin, a furan resin, a polyurethane resin and an aniline resin. The above-mentioned photo-curable resin may be used alone or in combination of two or more species.

Further, when the photo-curable resin is added, a photolatent cationic polymerization initiator is mixed as required in order to accomplish curing of the photo-curable resin. The above-mentioned photolatent cationic polymerization initiator is not particularly limited and examples of the initiators include ionic photolatent cationic polymerization initiators like onium salts such as aromatic diazonium salt, aromatic halonium salt and aromatic sulfonium salt, in which antimony hexafluoride, phosphorus hexafluoride and boron tetrafluoride are pair anions, and organic metal complexes such as iron-allene complex, titanocene complex and arylsilanol-aluminum complex; and nonionic photolatent cationic polymerization catalyst such as nitrobenzyl ester, sulfonic acid derivatives, phosphate, phenolsulfonate, diazonaphthoquinon and N-hydroxyimide sulfonate.

Thermoplastic elastomers may be mixed in the resin composition of the present invention to the extent of not impairing the attainment of issues of the present invention. These thermoplastic elastomers are not particularly limited and examples of them include styrenic elastomers, olef in elastomers, urethane elastomers, polyester elastomers and the like. These thermoplastic elastomers may be functional group modified in order to enhance compatibility with resin. These thermoplastic elastomers may be used alone or in combination of two or more species.

Crosslinked rubbers may be mixed in the resin composition of the present invention to the extent of not impairing the attainment of issues of the present invention. These crosslinked rubbers are not particularly limited and examples of them include isoprene rubber, butadiene rubber, 1,2-polybutadiene, styrene-butadiene rubber, nitrile rubber, butyl rubber, ethylene-propylene rubber, silicone rubber, urethane rubber and the like. These crosslinked rubbers are preferably functional group modified in order to enhance compatibility with resin. The above functional group modified crosslinked rubbers are not particularly limited and examples of them include epoxy modified butadiene rubber, epoxy modified nitrile rubber and the like. These crosslinked rubbers may be used alone or in combination of two or more species.

An engineering plastic may be mixed in the resin composition of the present invention to the extent of not impairing the attainment of issues of the present invention.

In the thermosetting resin composition containing the engineering plastic, if the laminar silicate is dispersed, the resin composition becomes resistant to embrittlement and exerts excellent electrical properties. And, by containing the engineering plastic, the thermosetting resin composition decreases in a linear expansion coefficient since it has a high Tg. Further, the elongation of the thermosetting resin composition can be furthermore enhanced and the embrittlement of the thermosetting resin composition is reduced by containing the engineering plastic.

The engineering plastic is preferably present as a dispersed layer at the time when the thermosetting resin composition is processed into a molded body. That the engineering plastic is present as a dispersed layer at the time when the thermosetting resin composition is processed into a molded body allows a molded body which is composed by using the thermosetting resin composition and a cured substance thereof to decrease in embrittlement and to exert excellent electrical properties while maintaining sufficient mechanical properties.

The engineering plastic is preferably dispersed finely at the time when the thermosetting resin composition is processed into a molded body. The engineering plastic is more preferably dispersed uniformly in a size of 3 $\mu$m or less. When the engineering plastic is dispersed finely, excellent electrical properties are exerted and resin's strength, elongation and fracture toughness are improved in a molded body composed by using the thermosetting resin composition and a cured body thereof.

The above-mentioned engineering plastic is not particularly limited and examples of the above engineering plastics include a polysulfone resin, a poly ether sulfone resin, a polyimide resin, a polyetherimide resin, a polyamide resin, a polyacetal resin, a polycarbonate resin, a polyethylene terephthalate resin, a polybutylene terephthalate resin, an aromatic polyester resin, a modified polyphenylene oxide resin, a polyphenylene sulfide resin, and a polyether ketone resin. In view of the compatibility with an epoxy resin or the properties which engineering plastic itself has, among others, at least one species of engineering plastic selected from the group consisting of a polysulfone resin, a poly ether sulfone resin, a polyimide resin and a polyetherimide resin is suitably employed. These engineering plastics may be used alone or in combination of two or more species.

The material for substrates and the film for substrates concerning the present invention are characterized by being composed by using the thermosetting resin composition concerning the present invention. In this case, molded shapes of the material for substrates and the film for substrates are not particularly limited but the rate of maintaining a shape in thermoforming is enhanced by using the thermosetting resin composition concerning the present invention. Accordingly, the material for substrates, having various shapes, can be formed according to the present invention. And, the material for substrates and the film for substrates concerning the present invention are excellent in mechanical properties, dimensional stability and heat resistance since the inorganic compound is mixed in the thermosetting resin in the above-mentioned specific amount.

And, in the thermosetting resin composition of the present invention, the inorganic compound is dispersed finely, particularly preferably in a size of nanometer in the thermosetting resin, it is possible to realize high transparency in addition to a low linear expansion coefficient, heat resistance and low water absorption. Therefore, the thermosetting resin composition of the present invention can be suitably used also as a material for forming an optical package, a material for forming an optical circuit such as a material for optical waveguides, a material for polymer optical fiber, a connecting material and a sealing material, and a material for optical communications.

When the thermosetting resin composition is used as the above material for optical communications, as a light source used for the optical communications, an arbitrary light source, which produces an arbitrary wavelength such as visible light, infrared rays and ultraviolet rays, can be used and examples of these light sources include laser, a light-emitting diode, a xenon lamp, an arc lamp, an light bulb and a fluorescent lamp.

The thermosetting resin composition of the present invention can be employed as a core layer and/or a clad layer of an optical waveguide.

The optical waveguide is composed of a core layer through which light is passed and a clad layer which is in contact with the core layer. If a refractive index of the core layer is denoted by Nk and a refractive index of the clad layer is denoted by Ng, the core layer having a small attenuation factor of light and the clad layer in contact with the core layer, which has a different refractive index, are constructed so as to satisfy the relationship of Nk > Ng with respect to light used for a light source.

Examples of the materials, which can be used as the core layer or clad layer other than the thermosetting resin composition of the present invention, include glass, quartz, a plastic fluororesin, a thermoplastic acrylic resin, and a fluorinated polyimide resin.

And, the thermosetting resin composition of the present invention can be used for a material for sensors in which a planar optical waveguide consisting of a core layer in flat plate form and a clad layer in thin flat plate form is formed, and a medium is provided for the thin clad layer on the side opposite to the core layer and light (evanescent wave) exuding to the medium side is used.

When the thermosetting resin composition of the present invention is used as the above-mentioned material for forming an optical circuit, a method of forming an optical circuit is, for example, as follows. The thermosetting resin composition of the present invention using a fluorinated polyimide resin as a thermosetting resin composition is dissolved in a solvent, and the resulting solution is applied onto a silicon substrate by spin coating as a lower clad layer and heated to form a lower clad, and thereon, the thermosetting resin composition of the present invention using a fluorinated polyimide which is a thermosetting resin having a higher refractive index than the lower clad layer is cured to form a core layer. After this, the core layer is patterned by photolithography or dry etching, and further the thermosetting resin composition of the present invention, which uses a fluorinated polyimide having a lower refractive index than the core layer as a thermosetting resin, is cured to form a clad layer similarly and thereby an optical circuit is formed.

A method of molding the resin composition of the present invention is not particularly limited and examples of these methods include an extrusion process in which the resin composition is melted and kneaded and then extruded with an extruder, and the extruded resin is molded into film form with a T die or a circular die; a casting process in which the resin composition is dissolved or dispersed in a solvent such as an organic solvent and the like, and then molded into film form by casting; and a dip molding process in which a base material, consisting of an inorganic material such as glass or an organic polymer, in cloth form or nonwoven fabric form is molded into film form by dipping this base material in varnish prepared by dissolving or dispersing the resin composition in a solvent such as an organic solvent and the like. In addition, the base material used in the above-mentioned dip molding process is not particularly limited and include, for example, glass cloth, aramid fiber and poly(p-phenylene benzoxazole) fiber.

The resin composition of the present invention obtained by the above-mentioned method is very suitable for usual molding of a curable resin such as compression molding, transfer molding, heat laminating, and SCM molding and also suitable for molding of transferring a desired core pattern using a die (stamper).

As described above, the thermosetting resin composition concerning the present invention and a resin sheet composed by using such a thermosetting resin composition are excellent in transparency. Therefore, alignment becomes easy in the case where the resin composition and resin sheet are used as a material of a clad layer in a core layer of a waveguide or as a base in applications such as a digital versatile disc (DVD) and a compact disc (CD) and a shape of a die is transferred to or formed on the resin composition concerning the present invention, or in the case of laminating the resin composition concerning the present invention as a electrical and electric material, particularly an insulating film or an adhesive film on a base material. Further, it also becomes easy to identify the presence of void due to involved air.

[Examples]

Hereinafter, the present invention will be described in detail by having specific examples of the present invention. However, the present invention is not limited to the following examples.

(Example 1)

In a beaker were put 70 parts by weight of an epoxy resin composition including 35 parts by weight of bisphenol A type epoxy resin (YD-8125 produced by Tohto Kasei Co., Ltd.) and 35 parts by weight of a solid epoxy resin (YP-55 produced by Tohto Kasei Co. , Ltd.), 2.7 parts by weight of dicyanazide (produced by Asahi Denka Co., Ltd., ADEKA HARDENER EH-3636), 1.2 parts by weight of modified imidazole (produced by Asahi Denka Co., Ltd. , ADEKA HARDENER EH-3366), 30 parts by weight of synthetic hectorite organized with dimethyldioctadecyl ammonium salt (LUCENTITE SAN manufactured by CO-OP CHEMICAL CO., LTD.) as laminar silicate, 200 parts by weight of dimethylformamide (produced by Wako Pure Chemical Industries, Ltd., analytical grade) as an organic solvent, and 200 parts by weight of toluene (produced by Wako Pure Chemical Industries, Ltd., analytical grade) as an organic solvent. After this, the resulting mixture was stirred for 1 hour with a stirrer and then deaerated to obtain a solution of resin and laminar silicate. Next, the obtained solution of resin and laminar silicate was applied onto a polyethylene terephthalate sheet to eliminate the solvent in this state. Next, an resin solution on the sheet was heated at 100°C for 15 minutes to prepare a not-yet-cured body having a thickness of 100 μm as a test sheet consisting of a resin composition. A not-yet-cured molded body in plate form was prepared by laminating 10 sheets of the test sheets so as to be 1 mm in thickness. Separately from this, a test sheet having a thickness of 1 mm was pressed for 1 minute at a pressure of 5 MPa with a die having a cylindrical cavity, of which a diameter and a depth are 100 μm/200 μm, 200 μm/400 μm and 400 μm/800 μm, respectively, in a flat press heated to 100°C to form an inverted U-shaped portion. Further, this not-yet-cured test sheet thus molded and the above-mentioned test sheet having a thickness of 100 μm were heated at 170°C for 1 hour to prepare a cured body molded and a molded body in plate form having a thickness of 100 μm.

(Example 2)

A resin composition and molded bodies were prepared by following the same procedure as in Example 1 except for using fumed silica (Reolosil MT-10 produced by Tokuyama Corporation) in place of synthetic hectorite (LUCENTITE SAN produced by CO-OP CHEMICAL CO., LTD.).

(Comparative Example 1)

A resin composition and molded bodies were prepared by following the same procedure as in Example 1 except for not mixing synthetic hectorite (LUCENTITE SAN produced by CO-OP CHEMICAL CO . , LTD.).

(Comparative Example 2)

A resin composition and molded bodies were prepared by following the same procedure as in Example 1 except for mixing 20 parts by weight of spherical silica (SILICA ACE QS-4 produced by MITSUBISHI RAYON CO., LTD.; average particle size 4 μm) in place of synthetic hectorite (LUCENTITE SAN produced by CO-OP CHEMICAL CO., LTD.).

(Example 3)

A resin composition and molded bodies were prepared by following the same procedure as in Example 1 except for changing an amount of synthetic hectorite (LUCENTITE SAN produced by CO-OP CHEMICAL CO., LTD.) to be mixed to 7 parts by weight.
(Example 4)
A resin composition and molded bodies were prepared by following the same procedure as in Example 1 except for changing an amount of synthetic hectorite (LUCENTITE SAN produced by CO-OP CHEMICAL CO., LTD.) to be mixed to 15 parts by weight.

<Evaluation>

With respect to the performance of the molded bodies in plate form prepared in Examples 1 to 4 and Comparative Examples 1 and 2, the following items were evaluated. The results of evaluations are shown in Table 1.

(1) Measurement of thermal expansion coefficient

With respect to a test piece prepared by cutting each molded body in plate form having a thickness of 100 $\mu$m into a size of 3 mm $\times$ 25 mm, using a TMA (thermomechanical analysis) apparatus (TMA/SS120C manufactured by Seiko Instrument Inc.), its temperature was increased at a temperature raising rate of 5 °C/minute and its average linear expansion coefficient was measured to determine the following items.
- An average linear expansion coefficient ($\alpha$1) at a temperature lower than the glass transition point of a resin composition by from 50°C to 10°C [°C$^{-1}$].
- An average linear expansion coefficient ($\alpha$2) at a temperature higher than the glass transition point of a resin composition by from 10°C to 50°C [°C$^{-1}$].

(2) Average distance between layers of laminar silicate

2$\theta$ of a diffraction peak obtained from the diffraction of a laminating face of the laminar silicate in the molded body in plate form having a thickness of 100 $\mu$m was measured using a X-ray diffractometer (RINT 1100 manufactured by Rigaku Corporation.). Spacingdof a (001) planeof the laminarsilicate was derived from the Bragg condition of the following equation (3) :
$$\lambda = 2d\sin\theta \quad (3),$$

and the obtained d is taken as an average interlayer distance (mm). In the above equation (3), $\lambda$ is 0.154 angstrom and $\theta$ represents a diffraction angle.

(3) Rate of laminar silicate dispersed in the form of a laminate of five layers or less, and rate of laminar silicate dispersed in the form of a laminate of three layers or more

A molded body in plate form having a thickness of 100 $\mu$m was observed under a magnification of 100000 times with a transmission electron microscope, and by counting the number of laminates of laminar silicate which can be observed ina certain area and the number of layers in these laminates, the number X of layers in total laminates and the number Y of layers in laminates dispersed in the form of a laminate of five layers or less, and the number Z of layers in laminates dispersed in the form of a laminate of three layers or more were determined. Using these X, Y and Z, a rate (%) of laminar silicate dispersed in the form of a laminate of five layers or less was derived from the following equation (4):

$$\text{Rate of laminar silicate dispersed in the form of a laminate of five layers or less (\%)} = (Y/X) \times 100 \quad (4),$$

and
a rate (%) of laminar silicate dispersed in the form of a laminate of three layers or more was derived from the following equation (5),

$$\text{Rate of laminar silicate dispersed in the form of a laminate of three layers or more (\%)} = (Z/X) \times 100 \quad (5),$$

a state of laminar silicate dispersing was evaluated according to the following criteria:

[Criteria]

○ The rate (%) of laminar silicate dispersed in the form of a laminate of five layers or less was 10% or more.
× The rate (%) of laminar silicate dispersed in the form of a laminate of five layers or less was less than 10%.

[Criteria]

○ The rate (%) of laminar silicate dispersed in the form of a laminate of three layers or more was 30% or more and 70% or less.

× The rate (%) of laminar silicate dispersed in the form of a laminate of three layers or more was less than 30% or more than 70%.

(4) Measurement of dispersion particle diameter of inorganic compound in resin

A molded body in plate form having a thickness of 100 $\mu$m was observed under a magnification of 10000 times with a transmission electron microscope, and a longer side of an inorganic compound, which can be observed in a certain area, was measured.

(5) Measurement of water absorption

A rectangular test piece was prepared by cutting a molded body in plate form having a thickness of 100 $\mu$m into a size of 3 cm $\times$ 5 cm, and after drying the test piece at 150°C for 5 hours, its weight (W1) was weighed. Next, the test piece was immersed in water and left standing for 1 hour in boiled water of 100°C, and then it was taken out and its weight (W2) was weighed after wiping the test piece well with waste. Water absorption was determined by the following equation:

$$\texttt{Water absorption (\%) = (W2-W1)/W1}\times\texttt{100.}$$

(6) Evaluation of moldability

In examples and Comparative examples, the moldability in molding was evaluated according the following directions. The results of evaluations are shown in Table 1. Further, the moldability 1, 2 and 3 in Table 1 correspond to the cases where H/Ds of the dimensions of the U-shaped groove of the die molding a molded body are 100 $\mu$m/200 $\mu$m, 200 $\mu$m/400 $\mu$m and 400 $\mu$m/800 $\mu$m, and a dimensional ratio H/D of a pre-curing molded sample was determined from a photograph obtained by photographing the molded sample in a slanting direction with a scanning electron microscope. The respective results on the pre-molding molded body are shown in table 1.

(7) Checking of ability to maintain shape

Samples molded in evaluating the post-curing moldability 1, 2 and 3 were heated at 170°C for 1 hour of the curing conditions in Example 1. After this, the samples were cooled at room temperature, and a dimensional ratio H/D of a post-curing molded sample was determined from a photograph obtained by photographing the molded sample in a slanting direction with a scanning electron microscope (SEM). On the samples molded in evaluating the above moldability 1, 2 and 3, the ability to maintain a shape 1, 2 and 3, respectively, was evaluated from the ratio between dimensional ratio H/D values determine before and after curing. The results of evaluations are shown in Table 1. In addition, a symbol ○ in Table 1 indicates that that the ratio between dimensional ratio H/D values measured before and after curing is 75% or more and a symbol × indicates that that the ratio between dimensional ratio H/D values measured before and after curing is less than 75%.
And, when a pre-curing vertical face $P_0$ is inclined after curing as shown in Figure 1, an angle $\theta$ which this inclined face forms with a horizontal plane was measured by a SEM. The case where $\theta$ is 80 to 90° angle is denoted by a symbol ○ and the case where $\theta$ is less than 80° angle or a shape cannot be maintained is denoted by a symbol ×. These results are shown in the following Table 1.

(8) Measurement of total light transmittance

A minimum value of light transmittance in a wavelength range of light required in accordance with uses is treated as total light transmittance, and in Examples and Comparative Examples, the total light transmittance is determined in a wavelength range of 190 to 3200 nm. The transmittance can be measured with UV-VIS Spectrophotometers (UV-3150 manufactured by SHIMADZU CORPORATION).
[Table 1]

| | Ex. | | | | Comp. Ex. | |
|---|---|---|---|---|---|---|
| | 1 | 2 | 3 | 4 | 1 | 2 |
| CTE ($\alpha$1) : $\times$10E-6(1/°C) | 54.0 | 59.5 | 69.5 | 64.3 | 121.5 | 109.3 |
| CTE ($\alpha$2) : $\times$10E-6(1/°C) | 67.2 | 190.3 | 138.5 | 122.6 | 957.3 | 450.7 |
| Average Distance Between Layers (nm) | 3.5< | — | 3.5< | 3.5< | — | — |
| Rate of Laminar Silicate of Five Layers or Less (%) | ○ | — | ○ | ○ | — | — |
| Rate of Laminar Silicate of Three Layers or More (%) | ○ | ○ | ○ | ○ | — | — |
| Dispersion Particle Diameter in Resin ($\mu$m) | <0.5 | <0.5 | <0.5 | <0.5 | — | 4.1 |
| Water Absorption (%) | 0.85 | 0.95 | 1.1 | 0.92 | 3.44 | 2.85 |
| Moldability 1 | 87 | 78 | 100 | 100 | N.D. | 40 |
| Moldability 2 | 100 | 100 | 100 | 100 | N.D. | 88 |
| Moldability 3 | 100 | 100 | 100 | 100 | 94 | 100 |
| Ability to Maintain a Shape 1: Evaluation of H/D | ○ | ○ | ○ | ○ | — | — |
| Ability to Maintain a Shape 2: Evaluation of H/D | ○ | ○ | ○ | ○ | — | × |
| Ability to Maintain a Shape 3: Evaluation of H/D | ○ | ○ | ○ | ○ | × | ○ |
| Ability to Maintain a Shape 1A: Evaluation of Angle θ | ○ | ○ | ○ | ○ | — | — |
| Ability to Maintain a Shape 2B: Evaluation of Angle θ | ○ | ○ | ○ | ○ | — | — |
| Ability to Maintain a Shape 3C: Evaluation of Angle θ | ○ | ○ | ○ | ○ | — | ○ |
| Total Light Transmittance (%) | 90 | 82 | 93 | 91 | 94 | 72 |

$\times$10E-6 Represents $\times10^{-6}$ N.D. indicates that the resin was not released from a die to be broken and this item could not be measured. In the evaluation of the ability to maintain a shape 1 to 3, a symbol - (minus) means that the evaluation was not done because of poor ability to maintain a shape.

**Claims**

1. A thermosetting resin composition containing100parts by weight of a thermosetting resin and 0.1 to 100 parts by weight of an inorganic compound dispersed in said thermosetting resin,
**characterized in that** the dispersion particle diameter of said inorganic compound is 2 $\mu$m or less and not less than 75% of the shape of an article molded before curing is maintained after the resin composition is cured.

2. The thermosetting resin composition according to claim 1, wherein said inorganic compound is an inorganic compound containing silicon and oxygen as a constituent element.

3. The thermosetting resincomposition according toclaim 1 or 2, wherein said inorganic compound is laminar silicate.

4. The thermosetting resin composition according to any one of claims 1 to 3, wherein said resin composition contains an epoxy resin as said thermosetting resin.

**5.** A material for substrates, **characterized in that** said material is composed by using the thermosetting resin composition according to any one of claims 1 to 4.

**6.** A film for substrates, **characterized in that** said film is composed by using the thermosetting resin composition according to any one of claims 1 to 4.

[FIG. 1]

## INTERNATIONAL SEARCH REPORT

| International application No. |
| --- |
| PCT/JP2004/018614 |

**A. CLASSIFICATION OF SUBJECT MATTER**
Int.Cl$^7$ C08L101/00, C08K3/00, C08L63/00, C08K3/34, H05K1/03

According to International Patent Classification (IPC) or to both national classification and IPC

**B. FIELDS SEARCHED**

Minimum documentation searched (classification system followed by classification symbols)
Int.Cl$^7$ C08L101/00, C08K3/00, C08L63/00, C08K3/34, H05K1/03

Documentation searched other than minimum documentation to the extent that such documents are included in the fields searched

| | | | |
| --- | --- | --- | --- |
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2003-313435 A (Sekisui Chemical Co., Ltd.), 06 November, 2003 (06.11.03), Claims; Par. Nos. [0017] to [0048], [0064] to [0083], [0097] to [0112], [0127] table 1 (Family: none) | 1-6 |
| X | JP 2003-26939 A (Sekisui Chemical Co., Ltd.), 29 January, 2003 (29.01.03), Claims; Par. Nos. [0014] to [0029], [0065] to [0090], [0112] to [0113], [0145] table 1, [0156] & WO 2002/46312 A1 & AU 200221097 A & EP 1350815 A1 & KR 2003064804 A & US 2004/53061 A1 & TW 559835 A & CN 1479768 A | 1-6 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 29 March, 2005 (29.03.05) | 19 April, 2005 (19.04.05) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

| | INTERNATIONAL SEARCH REPORT | International application No. |
|---|---|---|
| | | PCT/JP2004/018614 |

**C (Continuation). DOCUMENTS CONSIDERED TO BE RELEVANT**

| Category* | Citation of document, with indication, where appropriate, of the relevant passages | Relevant to claim No. |
|---|---|---|
| X | JP 2002-64276 A (Nippon Steel Chemical Co., Ltd.), 28 February, 2002 (28.02.02), Claims; Par. Nos. [0033] to [0046] & US 2002/51942 A1 | 1-2,4-6 |
| X | JP 10-4270 A (Sumitomo Bakelite Co., Ltd.), 06 January, 1998 (06.01.98), Claims; Par. Nos. [0023] to [0034] (Family: none) | 1-2,4-6 |
| P,A | JP 2004-244510 A (Sekisui Chemical Co., Ltd.), 02 September, 2004 (02.09.04), Claims (Family: none) | 1-6 |
| P,A | JP 2004-59918 A (Sekisui Chemical Co., Ltd.), 26 February, 2004 (26.02.04), Claims (Family: none) | 1-6 |

Form PCT/ISA/210 (continuation of second sheet) (January 2004)